# EUROPÄISCHE PATENTSCHRIFT

(11) **EP 0 816 818 B1**
(45) Veröffentlichungstag und Bekanntmachung des Hinweises auf die Patenterteilung: **23.04.2003**
(21) Anmeldenummer: 97108927.1
(22) Anmeldetag: 03.06.1997
(51) Int. Cl.: G01L 9/00, G01L 9/12, G01P 15/125

(54) **AUSLESESCHALTUNG FÜR KAPAZITIV MESSENDE SENSOREN**
MEASURING CIRCUIT FOR CAPACITIVE SENSORS
CIRCUIT DE MESURE POUR CAPTEURS CAPACITIFS

(30) Priorität: 26.06.1996 DE 19625666
(43) Veröffentlichungstag der Anmeldung: 07.01.1998
(73) Patentinhaber: Infineon Technologies AG, 81669 München (DE)
(72) Erfinder: Hierold, Christofer, Dr., 81739 München (DE); Noe, Reinhold, Prof. Dr., 33100 Paderborn (DE); Scheiter, Thomas, Dr., 80469 München (DE); Steger, Max, 81825 München (DE)
(74) Vertreter: Zimmermann & Partner

(56) Entgegenhaltungen:
- EP-B- 0 543 901
- WO-A-96/12339
- DE-A- 4 103 433
- PATENT ABSTRACTS OF JAPAN vol. 018, no. 667 (E-1645), 15.Dezember 1994 & JP 06 261557 A (SANKEN ELECTRIC CO LTD), 16.September 1994,
- PATENT ABSTRACTS OF JAPAN vol. 096, no. 002, 29.Februar 1996 & JP 07 260509 A (MURATA MFG CO LTD), 13.Oktober 1995,
- PATENT ABSTRACTS OF JAPAN vol. 009, no. 208 (E-338), 24.August 1985 & JP 60 072406 A (SHIMAZU SEISAKUSHO KK), 24.April 1985,

## Beschreibung

Die vorliegende Erfindung betrifft einen kapazitiv messenden Sensor als mikromechanisches Halbleiterbauelement und eine dafür vorgesehene Auslese- und Auswerteschaltung.

Für kapazitiv messende Sensoren wie z. B. Drucksensoren und Beschleunigungssensoren, die eine große Empfindlichkeit aufweisen, d. h. auf sehr kleine Änderungen einer Meßgröße hin ein auswertbares und auch sehr kleines Meßsignal liefern, sind Auswerteschaltungen erforderlich, die geringste Kapazitätsänderungen in ein Ausgangssignal umsetzen, das der Meßgröße eindeutig zugeordnet werden kann. Es sind daher Ausleseschaltungen gefordert, die für sehr kleine Kapazitäten und deren Änderungen bis in den Bereich von einigen 10 aF verwendet werden können und die zur monolithischen Integration zusammen mit kapazitiven Sensoren, die insbesondere als mikromechanisches Halbleiterbauelement, vorzugsweise in Silizium, realisiert werden, geeignet sind. Ein kapazitiv messender Drucksensor als mikromechanisches Bauelement ist z. B. in der DE 44 01 999 C2 beschrieben; ein kapazitiv messender Beschleunigungssensor als mikromechanisches Bauelement ist z. B. in der EP 0 543 901 B1 beschrieben. Die Ausleseschaltungen sollen mit Auswerteschaltungen gekoppelt werden können, die ein Eingangssignal in einen Bitstrom oder in ein digitales Wort, das von einem Mikroprozessor eingelesen werden kann, umwandeln. Wegen der sehr kleinen Ladungsmengen, die detektiert werden müssen, ist eine Technik erforderlich, die zum einen das Signal nicht verfälscht und zum anderen empfindlich genug ist, um ein Auslesen zu ermöglichen. Es werden zu diesem Zweck weitgehend herkömmliche analoge Verstärker verwendet, und das verstärkte Signal wird anschließend analog/digital gewandelt. Vereinzelt werden auch Σ-Δ-Modulatoren verwendet, wie das z. B. in der Veröffentlichung von C. Azeredo Leme und H. Baltes: "Interfaces for Microsensor Systems" in W. Sansen et al. (eds.): "Analog Circuit Design", Kluwer Academic Publishers, Dordrecht 1994, S. 163 bis 181, beschrieben ist.

Aufgabe der vorliegenden Erfindung ist es, eine Ausleseschaltung für sehr kleine Kapazitäten und einen damit betriebenen kapazitiv messenden Sensor erhöhter Empfindlichkeit anzugeben.

Diese Aufgabe wird mit der Ausleseschaltung mit den Merkmalen des Anspruches 1 und mit dem mikromechanischen Sensor mit den Merkmalen des Anspruches 4 oder 5 gelöst. Weitere Ausgestaltungen ergeben sich aus den jeweiligen abhängigen Ansprüchen.

Bei der erfindungsgemäßen Ausleseschaltung wird ein Σ-Δ-Modulator (im folgenden als SDM abgekürzt) 2. Ordnung mit Switched Capacitor Technik verwendet, wie er im Prinzip bekannt ist. Eine zu messende Kapazität wird mit drei weiteren Kapazitäten zu einer Brückenschaltung zusammengeschaltet, bei der je zwei der Kondensatoren in Reihe geschaltet sind und diese beiden Reihenschaltungen zueinander parallel geschaltet sind. Als Eingänge dieser Brückenschaltung sind Anschlüsse an den Enden dieser Reihenschaltungen und als Ausgänge Anschlüsse jeweils zwischen den hintereinander in Reihe geschalteten Kondensatoren vorgesehen. Diese Brückenschaltung ersetzt einen Teil der Eingangsstufe, die in herkömmlichen SDMs durch zwei geeignet in die Schaltung eingebaute Kondensatoren gebildet wird. In dieser Weise wird durch eine Verstimmung dieser Kapazitätsbrücke bei Änderung einer Kapazität (z. B. bei einer Änderung der Größen, die auf einen kapazitiv messenden Sensor einwirken) das Ausgangssignal (Bitstrom) des SDMs beeinflußt.

Bei einem erfindungsgemäß realisierten Sensor werden bevorzugt zwei gleichartige Sensorelemente, die ein kapazitives Signal liefern, gemeinsam verwendet. Die Kondensatoren oder als Kondensator wirkenden Teile dieser Sensoren, im folgenden als Meßkondensatoren bezeichnet, werden zusammen mit zwei Bezugskondensatoren so in die Brückenschaltung der erfindungsgemäßen Ausleseschaltung eingebaut, daß an jedem Eingang und an jedem Ausgang der Brückenschaltung genau ein Meßkondensator und ein Bezugskondensator angeschlossen ist. Falls zwei Sensorelemente verwendet werden, an denen eine Änderung der auf die Sensorelemente einwirkenden Größe zueinander gegensinnige Kapazitätsänderungen hervorrufen, werden die beiden Meßkondensatoren in Reihe geschaltet und die beiden Bezugskondensatoren in Reihe geschaltet.

Es folgt eine eingehendere Beschreibung der Ausleseschaltung und der damit realisierbaren Sensoren anhand der Figuren 1 bis 3.
- Fig 1: zeigt ein Beispiel der vollständigen Ausleseschaltung.
- Fig 2: zeigt ein Detail aus der Schaltung der Figur 1.
- Fig 3: zeigt ein Schema eines als Chip realisierten erfindungsgemäßen Sensors.

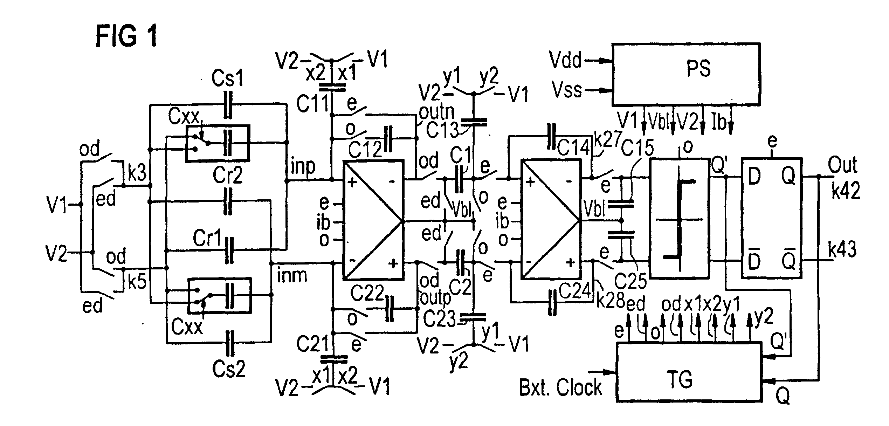

In der Figur 1 ist ein Beispiel einer erfindungsgemäßen Ausleseschaltung ausführlich dargestellt. Für den Σ-Δ-Modulator kommen grundsätzlich alle Ausführungen in Frage, die dieselbe Funktion besitzen. Die Eingangsstufe dieses Σ-Δ-Modulators wird wie gezeigt mit der Brückenschaltung modifiziert, so daß die Kondensatoren Cs1 und Cs2, die Meßkondensatoren, und die Kondensatoren Cr1 und Cr2, die Bezugskondensatoren, wie in der Schaltung links eingezeichnet angeschlossen sind. Die Potentiale V1 und V2 werden alternierend an die Eingänge k3 bzw. k5 der Brückenschaltung angelegt, wobei von den nachfolgenden Schaltern die beiden mit od bezeichneten geschlossen und die beiden mit ed bezeichneten geöffnet sind oder umgekehrt. Die Steuerung zur getakteten Umschaltung dieser Schalter erfolgt über eine Taktsteuerung TG (timing generator), die in dem in der Figur rechts eingezeichneten Schaltungsblock des SDMs angeordnet ist. Die Ausgänge der Brückenschaltung sind mit inp und inm bezeichnet. Die Stromversorgung ist als Schaltungsblock PS (power supply) dargestellt. Die Potentiale V1 und V2 werden vorzugsweise so gewählt, daß die Potentialdifferenzen zwischen dem eingezeichneten Mittenpotential Vbl und je einem der Potentiale V1 und V2 gleiche Beträge, aber entgegengesetzte Vorzeichen haben (z. B. V1 0,5 V, Vbl = 2 V, V2 = 3,5 V).

Die Brückenschaltung am Eingang des SDMs ist so ausgelegt, daß zwei Sensorelemente und zwei Bezugskondensatoren verwendet werden können, wodurch eine wesentliche Steigerung der Empfindlichkeit des gesamten Sensors erreicht wird, weil zwei gleichartige Sensorelemente für die Messung gleichzeitig verwendet werden und die Ausleseschaltung die gleichsinnigen Kapazitätsänderungen beider Sensorelemente so auswertet, daß sich eine deutliche Anhebung des Signalpegels gegenüber herkömmlichen Ausleseverfahren ergibt.

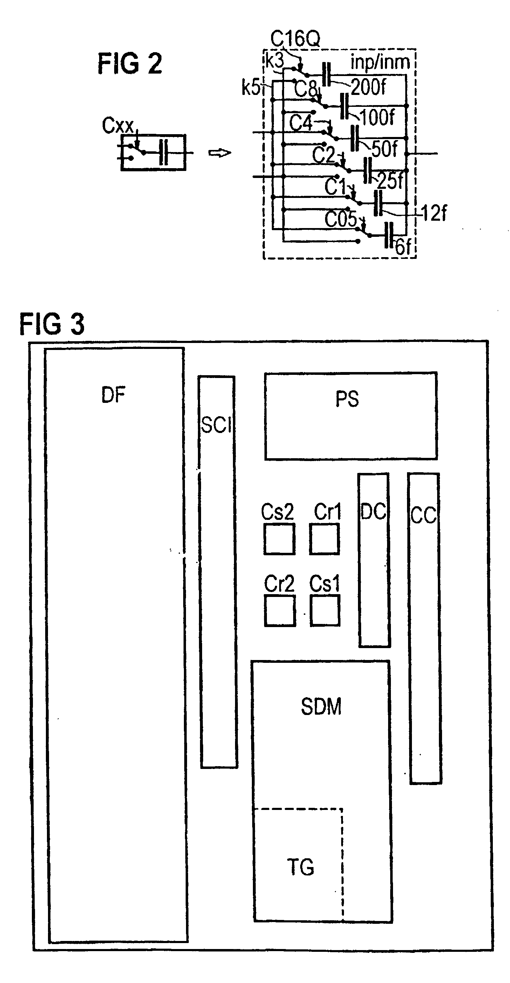

In einer bevorzugten Ausführungsform ist die Brückenschaltung zusätzlich mit Abgleichvorrichtungen versehen. Ein Beispiel für eine solche Abgleichvorrichtung ist in der Figur 2 genauer dargestellt. Diese Abgleichvorrichtung ist durch eine Anzahl von Kondensatoren gebildet, die parallel zueinander mit einem ihrer Anschlüsse jeweils an denselben Ausgang der Brükkenschaltung angeschlossen sind und deren Kapazitätswerte gewichtet sind. Die Kondensatoren können z. B. wie in der Figur eingetragen die 2ⁿ-fache Kapazität (n = 0, 1, 2, ... ) eines bestimmten Kapazitätswertes (hier 6 fF) besitzen. Diese Kapazitätswerte sind im Hinblick darauf gewählt, mit möglichst wenigen Kondensatoren eine dichte Folge einstellbarer Kapazitätswerte zu erreichen. Über Schalter C05, C1, C2, C4, C8, C16Q (in Figur 1 als Cxx zusammengefaßt) können die anderen Anschlüsse dieser Kondensatoren alternativ an den Eingang k3 oder den Eingang k5 der Brückenschaltung angeschlossen werden. Ein Umschalten innerhalb dieser Abgleichvorrichtung bewirkt daher, daß eine Kapazität, die parallel zu einem Kondensator der Brückenschaltung (z. B. einem der Meßkondensatoren) geschaltet ist, um einen bestimmten Wert angehoben wird und daß eine Kapazität, die parallel geschaltet ist zu dem mit diesem genannten Kondensator in Reihe geschalteten Kondensator (z. B. dem zu dem betreffenden Meßkondensator gehörenden Bezugskondensator) um denselben bestimmten Wert vermindert wird.

Vorzugsweise wird eine solche Abgleichvorrichtung in beiden Zweigen der Brückenschaltung eingesetzt, d. h. in beiden Reihenschaltungen je zweier Kondensatoren (Cs1 und Cr1 bzw. Cs2 und Cr2). Bei Verwendung zweier gleichartiger Sensorelemente mit gleich großen Kapazitäten werden die beiden Abgleichvorrichtungen so umgeschaltet, daß beide einem Sensorelement zugeordneten Gesamtkapazitäten (Meßkondensator und dazu parallelgeschaltete Kondensatoren der zugehörigen Abgleichvorrichtung) größer (kleiner) und beide Gesamtkapazitäten der zugeordneten Bezugskondensatoren (Bezugskondensator und dazu parallelgeschaltete Kondensatoren der Abgleichvorrichtung) kleiner (größer) werden. In denjenigen Fällen, in denen die Kapazitäten der Meßkondensatoren gleich groß sind (gleichartige Sensorelemente) und die Kapazitäten der Bezugskondensatoren gleich groß sind, aber die Kapazitäten von Meß- und Bezugskondensator verschieden sind, können durch geeignete Einstellung der Abgleichvorrichtungen die für den Abgleich der Brükkenschaltung maßgeblichen Gesamtkapazitäten so aneinander angepaßt werden, daß das Ergebnis einer Brückenschaltung aus vier Kondensatoren gleicher Kapazität entspricht. Das heißt also, daß die beiden Abgleichvorrichtungen in bezug auf das Verhältnis der Kapazitäten der zusammengehörenden Meß- und Bezugskondensatoren in beiden Zweigen gleichsinnig betätigt werden, um eine möglichst große Symmetrie der Brückenschaltung zu erhalten. Damit erreicht man eine Nullpunktverschiebung im Aussteuerbereich des SDMs.

Falls zwei kapazitiv messende Sensorelemente verwendet werden, deren Kapazitäten sich bei einer Änderung der detektierten Einflußgröße gegensinnig zueinander ändern, werden diese Sensorelemente in der Brückenschaltung an denselben Ausgang inm oder inp geschaltet, d. h. als Kondensatoren Cs1 und Cr1 oder als Kondensatoren Cs2 und Cr2.

Der Bitstrom am Ausgang des SDMs kann bei dem beschriebenen Ausführungsbeispiel mit einem Dezimierungsfilter 3. Ordnung gefiltert werden. Das daraus entstehende 16-bit-Wort, wird in ein serielles Format umgewandelt mit SCI-Protokoll und steht so für einen nachgeschalteten Mikroprozessor bereit.

Bei einer erfindungsgemäßen Ausführung eines Sensors als mikromechanisches Halbleiterbauelement werden zwei gleichartige kapazitiv messende Sensorelemente, z. B. zwei Drucksensormembranen oder zwei bewegliche Masseteile zur Bestimmung auftretender Trägheitskräfte (Beschleunigungssensor), auf einem Chip integriert. Die durch diese Sensorelemente gebildeten Meßkondensatoren, die auch bei Änderungen der von dem Sensor detektierten Einflußgrößen immer dieselbe Kapazität besitzen ― abgesehen von unvermeidlichen Fertigungstoleranzen ―, sind als Kondensator Cs1 und Cs2 in die Brückenschaltung der Ausleseschaltung geschaltet. Die Bezugskondensatoren Cr1 und Cr2 werden z. B. durch zwei ebensolche Sensorelemente gebildet, deren Kapazitäten aber durch weitere Mittel auf einem konstanten Wert, der vorzugsweise gleich einem Normal- oder Ruhewert ist, gehalten.

Bei einem Drucksensor werden die Sensorelemente durch eine elektrisch leitende Membranschicht gebildet, die über einem in dem Chip ausgebildeten Hohlraum angeordnet ist und die eine Oberfläche aufweist, die einem äußeren Medium, dessen Druck gemessen werden soll, zugänglich ist. Die Kapazität wird zwischen dieser Membranschicht und einem leitend dotierten Bereich in dem Chip gemessen. Die als Bezugskondensatoren zu verwendenden entsprechenden Sensorelemente sind dann z. B. durch eine entsprechende Membranschicht gebildet, die aber nach außen abgedeckt ist; der Hohlraum ist nicht vollständig ausgeätzt, so daß die Membranschicht auch in dieser Richtung festgehalten und daher unbeweglich ist. Wegen des wenigstens weitgehend vorhandenen Hohlraums unter der Membranschicht der als Bezugskondensatoren verwendeten Sensorelemente ist die Dielektrizitätskonstante hier näherungsweise gleich der Dielektrizitätskonstante der als Meßkondensatoren verwendeten (eigentlichen) Sensorelemente; daher sind alle vier Kapazitäten in ausreichender Näherung gleich groß. Ungenauigkeiten lassen sich wie oben beschrieben durch zwei Ausgleichvorrichtungen eliminieren. Die Kondensatoren dieser Ausgleichvorrichtungen werden vorzugsweise wie die übrigen Kondensatoren der Schaltung ausgebildet, z. B. durch voneinander isolierte Halbleiterschichten oder Leiterbahnen.

Bei einem erfindungsgemäß realisierten Beschleunigungssensor werden die Sensorelemente durch zwei gleichartige, elektrisch leitende, bewegliche Masseteile gebildet, die durch federnde Aufhängungen in einer Ruheposition gehalten werden, falls keine Trägheitskräfte in der Bewegungsrichtung auftreten. Die Kapazitäten werden zwischen diesem Masseteil und einer bezüglich des Chips festen Gegenelektrode gemessen. Die Bezugskondensatoren können hier ebenfalls durch zwei weitere, gleichartige Masseteile mit Gegenelektroden gebildet sein. Die Masseteile der Bezugskondensatoren werden nicht beweglich aufgehängt, sondern in der der Ruheposition entsprechenden Position fest verankert.

Falls zwei kapazitiv messende Sensorelemente verwendet werden, deren Kapazitäten sich bei einer Änderung der detektierten Einflußgröße gegensinnig zueinander ändern, wird dieselbe Ausleseschaltung verwendet, aber die Meßkondensatoren in denselben Zweig der Brückenschaltung in Reihe hintereinander geschaltet (als Cs1 und Cr1 oder als Cs2 und Cr2). Das ist z.B. der Fall bei einem Sensor, bei dem die Sensorelemente aus einer gemeinsamen beweglichen, elektrisch leitenden Mittenplatte und je einer fest darüber bzw. darunter angeordneten Gegenelektrode gebildet werden (Drucksensor oder Beschleunigungssensor), oder bei einem Sensor, bei dem ein bewegliches, elektrisch leitendes Masseteil zwischen zwei seitlich dazu auf entgegengesetzten Seiten angeordneten Gegenelektroden hin und her bewegt wird (Beschleunigungssensor).

Statt der fixierten zusätzlichen Sensorelemente, die von selbst zumindest angenähert dieselbe Kapazität besitzen wie die eigentlichen Sensorelemente, können die Bezugskondensatoren als Komponenten der elektronischen Schaltung, z. B. durch voneinander isolierte Halbleiterschichten oder Leiterbahnen, ausgebildet sein. Der dann in der Regel erforderliche Abgleich mit den Kapazitäten der Sensorelemente erfolgt dann durch die beschriebenen Abgleichvorrichtungen. Die Bezugskondensatoren können insbesondere Bestandteil der Abgleichvorrichtungen, also einer der in den Abgleichvorrichtungen zueinander parallelgeschalteten Kondensatoren, sein.

In Figur 3 ist ein Chip mit einem erfindungsgemäß realisierten Sensor im Schema dargestellt. Die Sensorelemente der Meßkondensatoren Cs1, Cs2 und die fixierten, aber sonst gleichartigen Sensorelemente der Bezugskondensatoren Cr1, Cr2 sind durch gleich große Drucksensormembranen angedeutet. Als Schaltungsblöcke sind die Stromversorgung PS, der Schaltungsteil der mit Kondensatoren bestückten Abgleichvorrichtungen CC und der Σ-Δ-Modulator SDM mit der Taktsteuerung TG dargestellt. Zur Verifikation der Funktionsweise der Schaltung kann mittels eingebauter Schalter die Brückenschaltung durch eine andere Brückenschaltung aus vier weiteren auf dem Chip integrierten Kondensatoren ersetzt werden. Diese zu Testzwekken verwendete weitere Brückenschaltung wird durch die als Schaltungsblock von Diagnosekondensatoren DC dargestellte Kondensatoranordnung gebildet. Der oben erwähnte Dezimierungsfilter DF (decimation filter) und die SCI-Schnittstelle SCI (clock divider und SCI-interface circuits) sind vorzugsweise ebenfalls auf dem Chip integriert.

In ähnlicher Weise wie die Diagnosekondensatoren können auch weitere Sensorkomplexe aus Sensorelementen, die einen anderen Empfindlichkeitsbereich aufweisen oder andere Einflußgrößen detektieren, in die Eingangsstufe des SDMs geschaltet werden. Auf diese Weise erhält man einen Mehrbereichs- bzw. einen Mehrfachsensor.

## Patentansprüche

1. Ausleseschaltung für kapazitiv messende Sensoren,
- bei der in einer Eingangsstufe eines Σ-Δ-Modulators eine Brückenschaltung aus vier Kondensatoren (Cs1, Cs2, Cr1, Cr2) vorhanden ist,
- bei der diese Brückenschaltung zwei Eingänge (k3, k5) und zwei Ausgänge (inm, inp) besitzt,
- bei der zu jedem Paar aus einem dieser Eingänge und einem dieser Ausgänge genau einer der vier Kondensatoren zwischen den Eingang und den Ausgang dieses Paares geschaltet ist und
- bei der Schalter (ed, od) und eine Taktsteuerung (TG) vorhanden sind, mit denen zwei unterschiedliche Potentiale im zeitlichen Wechsel alternierend an die beiden Eingänge der Brückenschaltung angelegt werden können.

2. Ausleseschaltung nach Anspruch 1,
- bei der die vier Kondensatoren durch zwei Paare von Kondensatoren gleicher Kapazität gegeben sind,
- bei der die Kondensatoren jedes dieser Paare mit verschiedenen Eingängen und verschiedenen Ausgängen der Brückenschaltung verbunden sind,
- bei der zwei Abgleichvorrichtungen vorhanden sind, die jeweils eine Anzahl von Kondensatoren und Schaltern umfassen, und
- bei der die Kondensatoren dieser Abgleichvorrichtungen parallel zueinander mit einem ihrer Anschlüsse jeweils an denselben Ausgang der Brückenschaltung angeschlossen sind und über die Schalter (C05, C1, C2, C4, C8, C16Q; Cxx) mit ihrem jeweils anderen Anschluß alternativ an einen der Eingänge der Brückenschaltung angeschlossen werden können.

3. Ausleseschaltung nach Anspruch 1, bei der die vier Kondensatoren dieselbe Kapazität aufweisen.

4. Sensor mit einer Ausleseschaltung nach einem der Ansprüche 1 bis 3,
- bei dem zwei gleichartige Sensorelemente vorhanden sind, die je einen Meßkondensator bilden,
- bei dem sich die Kapazitäten dieser Meßkondensatoren bei einer Änderung einer zu messenden Größe gleichsinnig zueinander ändern,
- bei dem diese Meßkondensatoren als zwei der vier Kondensatoren der Brückenschaltung geschaltet sind und
- bei dem die Meßkondensatoren mit verschiedenen Eingängen und verschiedenen Ausgängen der Brückenschaltung verbunden sind.

5. Sensor mit einer Ausleseschaltung nach einem der Ansprüche 1 bis 3,
- bei dem zwei gleichartige Sensorelemente vorhanden sind, die je einen Meßkondensator bilden,
- bei dem sich die Kapazitäten dieser Meßkondensatoren bei einer Änderung einer zu messenden Größe gegensinnig zueinander ändern,
- bei dem diese Meßkondensatoren als zwei der vier Kondensatoren der Brückenschaltung geschaltet sind und
- bei dem die Meßkondensatoren mit demselben Ausgang der Brückenschaltung verbunden sind.

6. Sensor nach Anspruch 4 oder 5,
- bei dem zwei gleichartige Bezugselemente vorhanden sind, die je einen Bezugskondensator bilden, deren Kapazität sich bei einer Änderung einer zu messenden Größe nicht ändert,
- bei dem diese Bezugselemente zu den Sensorelementen gleichartig strukturiert und so fixiert sind, daß die Kapazitäten der Bezugskondensatoren zumindest näherungsweise den Kapazitäten der Meßkondensatoren in einem vorgegebenen Grundzustand der Sensorelemente gleich sind, und
- bei dem diese Bezugskondensatoren als zwei der vier Kondensatoren der Brückenschaltung geschaltet sind.

7. Sensor nach einem der Ansprüche 4 bis 6 als Drucksensor, bei dem jedes Sensorelement eine zumindest bereichsweise elektrisch leitende Membran aufweist, die in einer für eine Druckmessung ausreichenden Weise verformbar ist, die mit einer Oberfläche einem Medium, dessen Druck gemessen werden soll, zugänglich ist und die einen Teil eines Meßkondensators bildet.

8. Sensor nach einem der Ansprüche 4 bis 6 als Beschleunigungssensor,
bei dem jedes Sensorelement ein zumindest bereichsweise elektrisch leitendes Masseteil aufweist, das in einer für eine Beschleunigungsmessung ausreichenden Weise beweglich ist, das durch eine federnde Aufhängung bei Abwesenheit von Trägheitskräften in einer Ruheposition gehalten wird und das einen Teil eines Meßkondensators bildet.

## Claims

1. Read-out circuit for sensors effecting capacitive measurement,
- in which a bridge circuit comprising four capacitors (Cs1, Cs2, Cr1, Cr2) is present in an input stage of a Σ-Δ modulator,
- in which the said bridge circuit has two inputs (k3, k5) and two outputs (inm, inp),
- in which, for each pair comprising one of the said inputs and one of the said outputs, precisely one of the four capacitors is connected between the input and the output of the said pair, and
- in which switches (ed, od) and a clock controller (TG) are present, by means of which two different potentials can be applied alternately to the two inputs of the bridge circuit in temporal alternation.

2. Read-out circuit according to Claim 1,
- in which the four capacitors are provided by two pairs of capacitors of identical capacitance,
- in which the capacitors of each of the said pairs are connected to different inputs and different outputs of the bridge circuit,
- in which two adjustment devices are present, each comprising a number of capacitors and switches, and
- in which the capacitors of the said adjustment devices are connected in parallel with one another by one of their terminals in each case to the same output of the bridge circuit, and can be alternatively connected to one of the inputs of the bridge circuit by their respective other terminal via the switches (C05, C1, C2, C4, C8, C16Q; Cxx).

3. Read-out circuit according to Claim 1,
in which the four capacitors have the same capacitance.

4. Sensor having a read-out circuit according to one of Claims 1 to 3,
- in which two sensor elements of identical type are present, which each form a measuring capacitor,
- in which the capacitances of the said measuring capacitors change in the same sense with respect to one another in the event of a change in a quantity to be measured,
- in which the said measuring capacitors are connected as two of the four capacitors of the bridge circuit, and
- in which the measuring capacitors are connected to different inputs and different outputs of the bridge circuit.

5. Sensor having a read-out circuit according to one of Claims 1 to 3,
- in which two sensor elements of identical type are present, which each form a measuring capacitor,
- in which the capacitances of the said measuring capacitors change in the opposite sense with respect to one another in the event of a change in a quantity to be measured,
- in which the said measuring capacitors are connected as two of the four capacitors of the bridge circuit, and
- in which the measuring capacitors are connected to the same output of the bridge circuit.

6. Sensor according to Claim 4 or 5,
- in which two reference elements of identical type are present, which each form a reference capacitor whose capacitance does not change in the event of a change in a quantity to be measured,
- in which the said reference elements are structured in identical fashion with respect to the sensor elements and fixed such that the capacitances of the reference capacitors are at least approximately equal to the capacitances of the measuring capacitors in a predetermined basic state of the sensor elements, and
- in which the said reference capacitors are connected as two of the four capacitors of the bridge circuit.

7. Sensor according to one of Claims 4 to 6 as pressure sensor,
in which each sensor element has a diaphragm which is electrically conductive at least in regions, which can be deformed in a manner that suffices for a pressure measurement, which is accessible by one surface to a medium whose pressure is to be measured, and which forms part of a measuring capacitor.

8. Sensor according to one of Claims 4 to 6 as acceleration sensor,
in which each sensor element has a mass element which is electrically conductive at least in regions, which is movable in a manner that suffices for an acceleration measurement, which is held in a rest position by a resilient suspension in the absence of inertial forces, and which forms part of a measuring capacitor.

## Revendications

1. Circuit de lecture pour capteurs à mesure capacitive,
- dans lequel il y a dans un étage d'entrée d'un modulateur Σ-Δ un circuit à pont composé de quatre condensateurs (Cs1, Cs2, Cr1, Cr2),
- dans lequel ce circuit à pont a deux entrées (k3, k5) et deux sorties (inm, inp),
- dans lequel, pour chaque paire composée de l'une de ces entrées et de l'une de ces sorties, exactement un des quatre condensateurs est branché entre l'entrée et la sortie de cette paire, et
- dans lequel il y a des interrupteurs (ed, od) et une commande d'horloge (TG) avec lesquels deux potentiels différents peuvent être appliqués en alternance temporelle aux deux entrées du circuit à pont.

2. Circuit de lecture selon la revendication 1,
- dans lequel les quatre condensateurs sont donnés par deux paires de condensateurs de même capacité,
- dans lequel les condensateurs de chacune de ces paires sont reliés à différentes entrées et différentes sorties du circuit à pont,
- dans lequel il y a deux dispositifs d'équilibrage qui comprennent chacun un certain nombre de condensateurs et d'interrupteurs, et
- dans lequel les condensateurs de ces dispositifs d'équilibrage sont raccordés parallèlement les uns aux autres par une de leurs bornes respectivement à la même sortie du circuit à pont et peuvent être raccordés par l'intermédiaire des interrupteurs (C05, C1, C2, C4, C8, C16Q ; Cxx) par leur autre borne respective en alternance à l'une des entrées du circuit à pont.

3. Circuit de lecture selon la revendication 1, dans lequel les quatre condensateurs ont la même capacité.

4. Capteur avec un circuit de lecture selon l'une des revendications 1 à 3,
- dans lequel il y a deux éléments capteurs de même type qui forment chacun un condensateur de mesure,
- dans lequel les capacités de ces condensateurs de mesure varient l'une par rapport à l'autre dans le même sens lors d'une variation d'une grandeur à mesurer,
- dans lequel ces condensateurs de mesure sont branchés en tant que deux des quatre condensateurs du circuit à pont, et
- dans lequel les condensateurs de mesure sont reliés à différentes entrées et différentes sorties du circuit à pont.

5. Capteur avec un circuit de lecture selon l'une des revendications 1 à 3,
- dans lequel il y a deux éléments capteurs de même type qui forment chacun un condensateur de mesure,
- dans lequel les capacités de ces condensateurs de mesure varient l'une par rapport à l'autre en sens contraire lors d'une variation d'une grandeur à mesurer,
- dans lequel ces condensateurs de mesure sont branchés en tant que deux des quatre condensateurs du circuit à pont, et
- dans lequel les condensateurs de mesure sont reliés à la même sortie du circuit à pont.

6. Capteur selon la revendication 4 ou 5,
- dans lequel il y a deux éléments de référence de même type qui forment chacun un condensateur de référence dont la capacité ne varie pas lors de la variation d'une grandeur à mesurer,
- dans lequel ces éléments de référence, par rapport aux éléments capteurs, sont structurés de la même manière et sont fixés de telle sorte que les capacités des condensateurs de référence sont au moins approximativement égales aux capacités des condensateurs de mesure dans un état de base prédéterminé des éléments capteurs, et
- dans lequel ces condensateurs de référence sont branchés en tant que deux des quatre condensateurs du circuit à pont.

7. Capteur selon l'une des revendications 4 à 6 formant capteur de pression, dans lequel chaque élément capteur comporte une membrane qui est électriquement conductrice au moins par zone, qui est déformable d'une manière suffisante pour une mesure de pression, qui est accessible par une surface à un fluide dont la pression doit être mesurée et qui forme une partie d'un condensateur de mesure.

8. Capteur selon l'une des revendications 4 à 6 formant capteur d'accélération, dans lequel chaque élément capteur comporte une partie de masse qui est électriquement conductrice au moins par zone, qui est mobile d'une manière suffisante pour une mesure d'accélération, qui est maintenue dans une position de repos par un accrochage élastique en l'absence de forces d'inertie et qui forme une partie d'un condensateur de mesure.
